Europäisches Patentamt

European Patent Office

Office européen des brevets

(11) Veröffentlichungsnummer: **0 335 389**
**A2**

(12) **EUROPÄISCHE PATENTANMELDUNG**

(21) Anmeldenummer: **89105614.5**

(22) Anmeldetag: **30.03.89**

(51) Int. Cl.4: **H01L 47/00**

(30) Priorität: **31.03.88 DE 3811116**

(43) Veröffentlichungstag der Anmeldung:
**04.10.89 Patentblatt 89/40**

(84) Benannte Vertragsstaaten:
**CH DE FR GB IT LI NL**

(71) Anmelder: **Max-Planck-Gesellschaft zur Förderung der Wissenschaften e.V.**
**Bunsenstrasse 10**
**D-3400 Göttingen(DE)**

(72) Erfinder: **Keilmann, Fritz, Dr.Dipl.-Phys.**
**Hagelsbrunnen 5a**
**D-7000 Stuttgart 80(DE)**

(74) Vertreter: **von Bezold, Dieter, Dr. et al**
**Dr. Dieter von Bezold Dipl.-Ing. Peter Schütz**
**Dipl.-Ing. Wolfgang Heusler Brienner Strasse 52**
**D-8000 München 2(DE)**

(54) **Frequenzverdreifacher für Mikrowellen.**

(57) Frequenzverdreifacher für Mikrowellen mit Frequenzen über etwa 30 GHz, z. B. 70 GHz, mit einem nichtlinearen Element aus einem schwach dotierten Halbleitermaterial, insbesondere n-Si mit einer Trägerkonzentration von $10^{13} cm^{-3}$ und weniger.

# FIG. 1

$f_0 = 20\,GHz\,/\,200\,KW$

$3f_0 = 210\,GHz$

## Frequenzverdreifacher für Mikrowellen

Die vorliegende Erfindung betrifft einen Frequenzverdreifacher für Mikrowellen, insbesondere für Mikrowellen mit Eingangs-Frequenzen über etwa 30 GHz bis beispielsweise etwa 100 oder 200 GHZ.

Mikrowellenstrahlung hoher Leistung wird beispielsweise zur Heizung von Fusionsplasmen benötigt. Mit den derzeitigen Mikrowellengeneratoren, z. B. Gyrotrons, lassen sich etwa 200 kW bei etwa 70 GHz erzeugen. Man benötigt jedoch Mikrowellenstrahlung noch höherer Frequenz, z. B. bis zu 300 GHz und mehr, um Plasmen mit höherer Elektronendichte als bisher effektiv heizen zu können. Die Entwicklung von Senderöhren für derart hohe Frequenzen wird mit zunehmender Frequenz immer schwieriger, da z. B. bei Gyrotrons immer höhere Magnetfelder benötigt werden und außerdem die mechanischen Toleranzen mit abnehmender Wellenlänge immer kritischer werden.

Aus einer Veröffentlichung von K. Seeger, J. Appl. Phys. 34, No. 6, Juni 1963, S. 1608-1611 ist es bekannt, elektromagnetische Schwingungen mit einer Frequenz von etwa 10 GHz mittels eines nichtlinearen Materials, nämlich n-Germanium mit einem spezifischen Widerstand von 5,5 Ohm cm in der Frequenz zu verdreifachen. Der maximale Wirkungsgrad, also das Verhältnis von Ausgangsleistung bei der verdreifachten Frequenz zur Eingangsleistung bei der Grundfrequenz betrug nur etwa 0,95% und es wird am Ende dieser Veröffentlichung erwähnt, daß die Leistung der erzeugten dritten Oberwelle mit zunehmender Frequenz abnimmt.

Aus einer Veröffentlichung von A. Mayer und F. Keilmann, Physical Review B, 33, No. 10, 15. Mai 1986, S. 6962-6968 ist es bekannt, daß im fernen Infrarot eine Frequenzverdreifachung mit Hilfe von dotierten Halbleitermaterialien, wie Ge, Si und GaAs erreicht werden kann, wobei ein Wirkungsgrad von $10^{-3}$ gemessen wurde.

Es wurde nun überraschenderweise gefunden, daß sich Mikrowellen mit Frequenzen über etwa 30 GHz, z. B. 50 GHz und darüber, durch Hindurchleiten durch oder Wechselwirkung mit schwach dotierten Halbleitermaterialien, vorzugsweise n-Si, mit einer Dotierungsstoffkonzentration in der Größenordnung von $10^{13} cm^{-3}$ und weniger, bei hohen Leistungen der Grundwelle mit hoher Effizienz verdreifachen lassen, z. B. mit einem Wirkungsgrad von über 50% bei einer Frequenzverdreifachung von Mikrowellenstrahlung mit einer Frequenz von 70 GHz und einer Leistung von 200 kW.

Bevorzugte Ausführungsformen der Erfindung weisen einzelne, mehrere oder alle folgenden Merkmale auf: Die Trägerkonzentration im Halbleitermaterial ist kleiner als $10^{13} cm^{-3}$ bis herunter zu $10^{12} cm^{-3}$ und weniger; das Halbleitermaterial ist n-leitendes Silicium; das Halbleitermaterial bildet einen orientierten Einkristall-Körper; die Eingangsleistung ist größer als 10kW, im speziellen größer als 100kW.

Es wurde gefunden, daß bei einer Frequenzverdreifachung von elektromagnetischen Schwingungen im Mikrowellenbereich über etwa 30 GHz bei schwach dotierten Halbleitern ein ganz anderer Mechanismus wirksam wird als bei niedrigeren Frequenzen von z. B. 10 GHz und höheren Dotierungen, wie sie von Seeger (l.c.) untersucht wurden. Bei einer Grundfrequenz in der Größenordnung von 10 GHz tritt nämlich ein periodisches Aufheizen und Abkühlen des gesamten Elektronengases im nichtlinearen Material im Rhythmus der Grundfrequenz ein. Dieser Heiz/Kühlzyklus wird mit zunehmender Grundfrequenz immer ineffektiver, da die Temperatur der Elektronen der Grundschwingung immer weniger folgen kann, so daß die Modulation der Temperatur und damit der Wirkungsgrad der Frequenzverdreifachung mit zunehmender Frequenz gegen null gehen. Bei der Erfindung wird dagegen ein völlig anderer Mechanismus ausgenutzt. Es hat sich gezeigt, daß bei Frequenzen über etwa 30 GHz, z. B. 70 GHz und mehr, und Trägerkonzentrationen in der Größenordnung von $10^{13} cm^{-3}$ und weniger, die Elektronen quasi isoliert voneinander schwingen und diese Schwingung wegen der Wechselwirkung der Elektronen mit dem Kristallgitter und wegen einer geringfügigen Abhängigkeit der Stoßhäufigkeit von der Elektronengeschwindigkeit nicht völlig harmonisch verläuft. Daß diese Effekte im Mikrowellenbereich, also z. B. bei Frequenzen von etwa 50 oder 70 GHz bis 100 oder 150 GHz und darüber zu einem überraschend hohen Frequenzverdreifachungswirkungsgrad führen, kann auch aus der Veröffentlichung von Mayer und Keilmann (l.c ) nicht geschlossen werden.

Im folgenden werden bevorzugte Ausführungsbeispiele der Erfindung unter Bezugnahme auf die Zeichnungen näher erläutert, dabei werden auch noch weitere Merkmale, Vorteile und Weiterbildungen der Erfindung zur Sprache kommen. Es zeigen:

Fig. 1 eine stark vereinfachte Darstellung eines Frequenzverdreifachers gemäß einer ersten Ausführungsform der Erfindung und

Fig. 2 eine entsprechende Darstellung einer zweiten Ausführungsform der Erfindung.

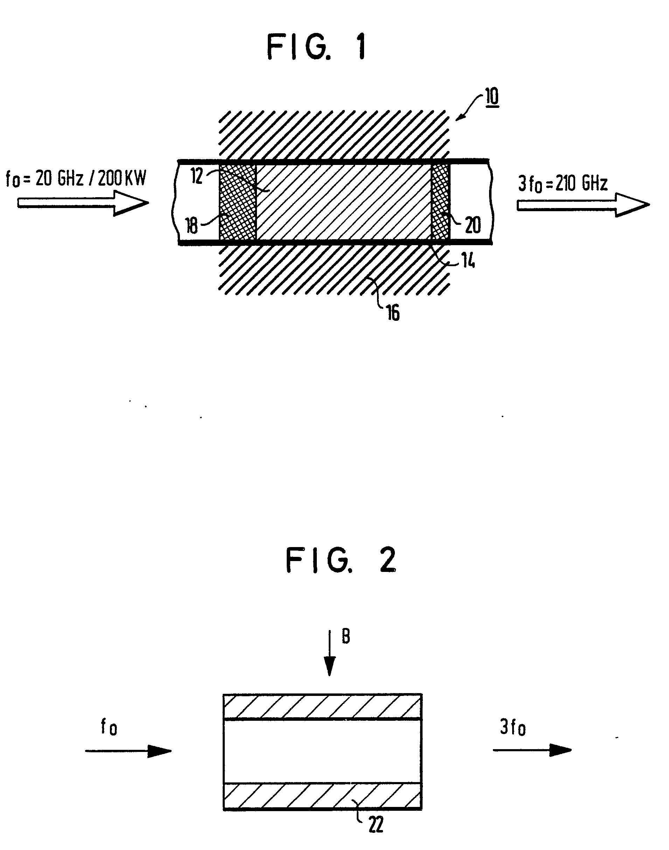

In Fig. 1 ist als erstes Ausführungsbeispiel der Erfindung ein Frequenzverdreifacher 10 dargestellt, der als nichtlineares Element einen Kristall 12 aus schwach dotiertem n-Si mit einer Trägerkonzentration von $10^{13}$ cm$^{-3}$ oder weniger enthält. Die Länge des Halbleiterkristalles 12 in der Fortpflanzungsrichtung der Mikrowellen kann zwischen 1 und 50 cm liegen. Der Halbleiterkristall 12 ist in einem Hohlleiterabschnitt 14 angeordnet, der einen Teil einer nicht näher dargestellten Mikrowellenleitung bildet, und er ist außen mit einer nur schematisch dargestellten Kühlvorrichtung 16, z. B. einem Flüssigkeitskühlmantel umgeben. In die eine, eingangsseitige (in Fig. 1 linke) Stirnfläche des Kristalles 12 wird die zu verdreifachende Mikrowellenstrahlung (Grundwelle) eingestrahlt, die bei dem dargestellten Ausführungsbeispiel eine Frequenz von 70 GHz und eine Leistung von 200 kW hat. Um Reflexionen zu verhindern, ist an der eingangsseitigen Stirnseite des Kristalles 12 ein Anpassungselement 18 vorgesehen.

Aus der anderen, ausgangsseitigen Stirnfläche (in Fig 1 rechts) wird die verdreifachte Mikrowellenstrahlung (dritte Harmonische), die hier also eine Frequenz von 210 GHz hat, ausgekoppelt. Auch hier kann ein Anpassungselement 20 vorgesehen sein, das eine möglichst vollständige Auskopplung der verdreifachten Strahlung gewährleistet.

Die Anpassungselemente 18, 20 können entweder Viertelwellenlängenschichten mit passendem Brechungsindex sein und z. B. aus Quarz bestehen, oder durch eine entsprechende Konfiguration der Einkoppel- und Auskoppelfläche, z. B. durch eine Oberflächenkorrugation, gebildet werden. Eine weitere Möglichkeit besteht darin, die Eintrittsfläche und die Austrittsfläche jeweils im Brewster-Winkel zur Eintritts- bzw. Austrittsrichtung der betreffenden Mikrowellenstrahlung anzuordnen, so daß ein reflexionsfreies Eintreten bzw. Austreten gewährleistet ist.

Silicium ist anderen Halbleitermaterialien, wie Germanium oder Galliumarsenid wegen seiner leichteren Verfügbarkeit vorzuziehen. n-leitendes Silicium hat außerdem noch den besonderen Vorteil, daß die Nichtlinearität bei sehr hohen Intensitäten nicht abnimmt, wie es bei n-Ge und n-GaAs beobachtet wurde.

Um eine optimale Nichtlinearität zu erreichen, soll ein orientierter Einkristall benutzt werden, d. h. die Richtung des elektrischen Vektors der Mikrowellenschwingung soll in etwa mit der |100|-Richtung des Siliciumeinkristalles zusammenfallen. Daß eine niedrige Elektronendichte vorteilhaft ist, wurde bereits erwähnt. Man erreicht dadurch auch, daß sich die Verlustwärme auf ein hinreichend großes Volumen verteilt.

Die Kühlvorrichtung 16 kann aus Kupferplatten bestehen, die thermisch mit dem Halbleiterkristall 12 oder mit dem diesen enthaltenden Hohlleiterabschnitt 14 gekoppelt sind, oder sie kann den Hohlleiterabschnitt bilden. Der Kristall 12 kann auch frei, d. h. ohne umgebenden Hohlleiterabschnitt oder Hohlraumresonator verwendet werden. In diesem Falle erfolgt die Halterung durch dielektrische Bauteile und die Kühlung zweckmäßigerweise durch eine die Mikrowellen möglist wenig absorbierende Flüssigkeit, wie Alkohol. Die Ein- und Auskopplung der Mikrowellenstrahlung kann in diesem Falle durch Hornstrahler oder dergl. erfolgen.

Die Kühlung des Kristalls auf z. B. 70 K und darunter vermindert die Mikrowellenabsorption und erhöht gleichzeitig die Wärmeleitfähigkeit.

Wenn sich eine Phasen-Fehlanpassung störend bemerkbar macht, ist eine Phasenanpassung dadurch zu erreichen, daß man den Halbleiterkristall selbst als Hohlleiterabschnitt 22 ausbildet, wie es in Fig. 2 vereinfacht dargestellt ist, und daß man die Randbedingungen derart wählt, daß die Wellenleiterdispersion die Materialdispersion kompensiert. Eine Ausbildung des Halbleiterkörpers als Hohlleiter ermöglicht außerdem die Modenzusammensetzung so zu steuern, daß ein weitgehend flaches Intensitätsprofil entsteht.

Mittels eines äußeren Magnetfeldes B, wie es in Fig. 2 schematisch angedeutet ist, kann eine resonante Erhöhung der Nichtlinearität sowie eine Phasenanpassung bewirkt werden. Das Magnetfeld zwingt die freien Elektronen zwischen den Stößen auf Kreisbahnen, wobei im Mikrowellengebiet die Zyklotronresonanz bei einigen Zehntel Tesla (einigen Kilogauß) liegt. Die dabei auch auftretenden dispersiven Effekte können wie die vom Hohlleiter herrührende Dispersion dadurch zur Phasenanpassung ausgenutzt werden, daß man die intrinsische Dispersion des nichtlinearen Mediums kompensiert, also die Differenz der Brechungsindizes für die Grundwelle bzw. die Oberwelle zu null macht, damit diese Wellen gleich schnell laufen, da dann die Energiekonversion optimal ist.

Es können mehrere Frequenzverdreifacher der beschriebenen Art hintereinander geschaltet werden. So läßt sich z. B. durch Hintereinanderschaltung zweier Frequenzverdreifacher die neunte Harmonische der Grundwelle effektiv erzeugen.

## Ansprüche

1. Frequenzverdreifacher für Mikrowellen mit einem Körper aus einem nichtlinearen Material, mit dem die Mikrowellen in Wechselwirkung treten, **dadurch gekennzeichnet,** daß die Mikrowellen eine Frequenz über etwa 30 GHz aufweisen und daß das nichtlineare Material ein schwach dotiertes Halbleitermaterial ist.

2. Frequenzverdreifacher nach Anspruch 1, **dadurch gekennzeichnet,** daß der Körper ein Einkristall ist.

3. Frequenzverdreifacher nach Anspruch 1 oder 2, **dadurch gekennzeichnet**, daß das nichtlineare Material n-leitendes Silicium mit einer Trägerkonzentration von höchstens etwa $10^{13}\text{cm}^{-3}$ ist.

4. Frequenzverdreifacher nach Anspruch 3, **dadurch gekennzeichnet**, daß die Trägerkonzentration in der Größenordnung von $10^{12}\text{cm}^{-3}$ liegt.

5. Frequenzverdreifacher nach einem der vorhergehenden Ansprüche, **dadurch gekennzeichnet**, daß der Körper aus dem nichtlinearen Material einen Hohlleiterabschnitt bildet.

6. Frequenzverdreifacher nach einem der vorhergehenden Ansprüche, **gekennzeichnet durch** eine Vorrichtung zum Erzeugen eines Magnetfeldes im nichtlinearen Material.

7. Frequenzverdreifacher nach Anspruch 6, **dadurch gekennzeichnet**, daß die Feldstärke des Magnetfeldes in der Größenordnung von einigen Zehntel Tesla liegt.

8. Frequenzverdreifacher nach einem der vorhergehenden Ansprüche, **dadurch gekennzeichnet**, daß der Körper aus dem nichtlinearen Material mit einer Kühlvorrichtung versehen ist.

# FIG. 1

$f_0 = 20 \text{ GHz} / 200 \text{ KW}$

$3f_0 = 210 \text{ GHz}$

10

12

18

20

14

16

# FIG. 2

B

$f_0$

$3f_0$

22